Europäisches Patentamt

European Patent Office

Office européen des brevets

(19)

(11) Veröffentlichungsnummer: **0 429 461 B1**

## (12) EUROPÄISCHE PATENTSCHRIFT

(45) Veröffentlichungstag der Patentschrift: **08.09.93**

(51) Int. Cl.5: **H05K 13/00**

(21) Anmeldenummer: **89906772.2**

(22) Anmeldetag: **15.06.89**

(86) Internationale Anmeldenummer:
**PCT/EP89/00676**

(87) Internationale Veröffentlichungsnummer:
**WO 90/01862 (22.02.90 90/05)**

(54) **PROJEKTIONSKOPF.**

(30) Priorität: **03.08.88 DE 3826442**

(43) Veröffentlichungstag der Anmeldung:
**05.06.91 Patentblatt 91/23**

(45) Bekanntmachung des Hinweises auf die
Patenterteilung:
**08.09.93 Patentblatt 93/36**

(84) Benannte Vertragsstaaten:
**AT BE CH DE FR GB IT LI LU NL SE**

(56) Entgegenhaltungen:
**WO-A-88/04121**
**DE-A- 2 716 548**
**DE-A- 2 751 651**
**US-A- 4 314 154**

(73) Patentinhaber: **ROYOCAD GESELLSCHAFT
FÜR HARD- UND SOFTWARE MBH
Hindenburgallee 1
D-85560 Ebersberg(DE)**

(72) Erfinder: **STÜCKLER, Gerd
Leerberg, 46
D-8180 Tegernsee(DE)**

(74) Vertreter: **Prechtel, Jörg, Dipl.-Phys. Dr. et al
Patentanwälte H. Weickmann, Dr. K. Fincke
F.A. Weickmann, B. Huber Dr. H. Liska, Dr. J.
Prechtel Kopernikusstrasse 9 Postfach 86 08
20
D-81635 München (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen Projektionskopf für einen Leuchtpunkt auf einer Fläche, insbesondere einer Montagefläche eines Bestückungstisches, zur Bestückungs-Ortsanzeige, mit
- einem Trägerteil,
- einer Punktlichtquelle, insbesondere in Form einer rückwärtig beleuchteten Lochblende,
- einem am Träger beweglich angeordneten Halter für die Punkt-Lichtquelle und
- einer am Trägerteil angeordneten Abbildungsoptik zur Abbildung der Punktlichtquelle als Leuchtpunkt auf der Fläche mit wenigstens einem am Trägerteil beweglich angebrachten optischen Element zur wahlweisen Verlagerung des Leuchtpunkts auf die Fläche.

Ein Projektionskopf dieser Art ist aus der DE-C-27 16 548 bekannt. Hierbei ist das gesamte Objektiv 26 in zwei zueinander und zur optischen Achse senkrechten Richtungen X und Y linear beweglich zur dementsprechenden Leuchtpunktbewegung auf der Fläche. Ein Halter 16 sowohl für die punktförmige Lichtquelle in Form einer Lochblende 24 als auch für die rückwärtige Lochblendenbeleuchtung 20 ist am Projektionskopf kugelgelenkig gelagert mit Gelenk-Drehpunkt im Loch der Lochblende. Über eine Schleppkupplung wird der tubusförmige Halter vom Objektiv mitgenommen. Durch diese Maßnahmen wird eine ausreichende Ausleuchtung der Lochblende sowie der Eintrittspupille des Objektivs erhalten, um eine ausreichende Helligkeit des abgebildeten Leuchtpunkts auch in den Eckbereichen der Projektionsfläche bzw. Montagefläche zu erhalten. Diese bekannte Anordnung hat sich bewährt. Der bauliche Aufwand ist jedoch ziemlich groß. So muß zur Erzielung einer ausreichend genauen Ortsanzeige eine sehr gut auf Verzeichnung korrigierte und daher relativ teure Abbildungsoptik verwendet werden. Einfache Objektive haben nämlich von Objektiv zu Objektiv unterschiedliche Verzeichnungseigenschaften, was zu ungenauer Abbildung führt. Die beschriebenen Maßnahmen zur Ausleuchtung der Lochblende und des Objektivs verkomplizieren den Aufbau. Ferner ist der Bauaufwand für die Bedienungsmechanik zur Bewegung des gesamten, relativ schweren Objektivs in den beiden kartesischen Koordinatenrichtungen relativ aufwendig aufgrund der geforderten Präzision und Flinkheit der Bewegung.

Die Aufgabe der Erfindung liegt darin, einen Projektionskopf der eingangs genannten Art mit scharfer Leuchtpunkt-Abbbildung auch in Randbereichen der Montagefläche bei vereinfachtem Aufbau bereitzustellen.

Diese Aufgabe wird dadurch gelöst,

- daß die Abbildungsoptik eine am Trägerteil ortsfest angebrachte Abbildungslinse oder -Linsengruppe umfaßt,
- daß das wenigstens eine optische Element am Trägerteil schwenkbar gelagert ist, und
- daß der Lichtquellen-Halter samt Punktlichtquelle gegenüber der Abbildungslinse oder -Linsengruppe in Richtung der optischen Achse in Abhängigkeit vom jeweiligen Schwenkwinkel des wenigstens einen optischen Elements auslenkbar ausgebildet ist.

Die Abbildungslinse bzw. -Linsengruppe ist also ortsfest am Trägerteil angebracht, so daß die Ausleuchtung der Lochblende sowie des Objektivs keine besonders aufwendigen Maßnahmen erfordert. Es kann eine einfache Abbildungslinse bzw. Abbildungslinsengruppe eingesetzt werden, da die abzubildende Punktlichtquelle stets am selben Ort auf der optischen Achse verbleibt. Die bei Einsatz des wenigstens einen schwenkbar gehalterten optischen Elements unvermeidlich auftretende "Bildfeldwölbung" (Fläche in der die zur Punktlichtquelle (im wesentlichen stationärer Objektpunkt) konjugierten und damit randscharfen Bildpunkte der Punktlichtquelle bei Strahlablenkung durch die optischen Elemente liegen), die bei der üblichen ebenen Projektionsfläche bzw. Montagefläche zu bereichsweise unscharfer Abbildung führen würde, wird durch die Auslenkung der Punktlichtquelle in Richtung der optischen Achse in Abhängigkeit vom jeweiligen Schwenkwinkel zumindest angenähert beseitigt, so daß eine scharfe Leuchtpunktabbildung weiterhin gewährleistet ist.

Es ist bereits vorgeschlagen worden, als Lichtquelle einen Laser sowie als optische Elemente zwei verschwenkbare Spiegel zu verwenden, die den Lichtstrahl des Lasers ablenken und als Leuchtpunkt auf die Montagefläche projizieren (DE-C-27 51 651). Der Laser sorgt für eine ausreichende Schärfe des Leuchtpunkts auch in den Eckbereichen der Projektionsfläche bzw. Montagefläche, da wegen der Parallelität und des geringen Durchmessers des Lichtstrahls die Abbildungsschärfe trotz je nach Ablenkwinkel unterschiedlicher Entfernungen zwischen Spiegel und Projektionsfläche akzeptabel bleibt, was z.B. bei einem divergenten Lichtstrahl nicht der Fall wäre. Nachteilig an dieser bekannten Anordnung ist jedoch nicht nur die Notwendigkeit der Bereitstellung eines vergleichsweise teuren Lasers, sondern auch das vom ergonomischen Standpunkt aus ungünstige Laserlicht. Der Laser-Leuchtpunkt szintiliert, so daß er als unscharf empfunden wird. Er ist nicht weiß sondern monochromatisch, so daß er nicht farbig moduliert werden kann. Auch müssen Maßnahmen getroffen werden, das menschliche Auge vor gefährlichen Leuchtdichten zu schützen. Diese Nachteile vermeidet die erfindungsgemäße Anordnung. Es können herkömmliche inkohärente, divergente Lichtquellen, z.B. einfache Halogen-Lampen geringer Leistung, verwendet werden. Zur Ausleuchtung der den Leuchtpunkt formenden Blende und der Objektiveintrittsöffnung genügt ein einfacher unbewegter Kondensor, da die Bewegung der Blende in Richtung der optischen Achse je nach Objektivbrennweite nur einige Zehntel Millimeter beträgt. Da lediglich eine scharfe Abbildung des Leuchtpunktes auf der optischen Achse der Abbildungsoptik erforderlich ist, können besonders lichtstarke und dennoch billige Abbildungslinsen oder -Linsengruppen eingesetzt werden; Verzerrungen außerhalb der optischen Achse sind ohne Bedeutung. Die schwenkbaren Spiegel benötigen keinen leistungsstarken Drehantrieb, da sich die Spiegelgröße lediglich nach dem Durchmesser der Austrittsöffnung der Abbildungslinse bzw. -Linsengruppe und den maximalen Spiegel-Schwenkschwinkeln richtet. Es ergeben sich im allgemeinen relativ kleine Spiegelabmessungen und damit Spiegelmassen, so daß auch bei niedrigen Antriebsleistungen ausreichend große Drehbeschleunigungen erreicht werden können.

In Weiterbildung der Erfindung wird vorgeschlagen, daß bei Einsatz eines ersten schwenkbeweglichen optischen Elements mit einer ersten Schwenkachse und eines zweiten schwenkbeweglichen optischen Elements mit einer zur ersten Schwenkachse senkrechten zweiten Schwenkachse jedem Schwenkwinkel des ersten optischen Elements jeweils ein erster Auslenkwert und jedem Schwenkwinkel des zweiten optischen Elements jeweils ein zweiter Auslenkwert zugeordnet ist, und daß die Auslenkung der Punktlichtquelle vom jeweiligen ersten und zweiten Auslenkwert abhängig ist.

Auch wird vorgeschlagen, daß die Auslenkung der Punktlichtquelle von einem Summenwert des jeweiligen ersten und zweiten Auslenkwerts abgeleitet ist. Diese im Grunde eine skalare Addition der ersten und zweiten Auslenkwerte darstellende Summenbildung läßt sich mechanisch am einfachsten realisieren und führt dabei zu ausreichender Korrektur der durch die Spiegel-Ablenkung des Lichtstrahls verursachten Bildfeldwölbung.

Ferner wird wenigstens eine Hebelanordnung vorgeschlagen zur Umsetzung der Schwenkbewegung des wenigstens einen optischen Elements in eine entsprechende Auslenkbewegung der Punktlichtquelle. Diese Hebelanordnungen erübrigen den Einsatz komplizierterer Bauelemente, wie z.B. von Drehwinkelfühlern und Stellmotoren zur Auslenkung des Lichtquellenhalters.

Aufgrund der schwenkbaren Ausbildung sowohl des Trägerteils als auch des wenigstens einen optischen Elements können beide Teile in besonders einfacher Weise miteinander zur Bildfeldwölbung-Korrektur mechanisch verkoppelt werden, und zwar dadurch, daß der Lichtquellenhalter jeweils über eine Kniegelenkhebel-Anordnung mit zur Schwenkachse des jeweiligen optischen Elements paralleler Kniegelenkachse mit dem wenigstens einen schwenkbeweglichen optischen Element verbunden ist.

Die bereits erwähnte skalare Addition der ersten und zweiten Auslenkwerte kann mechanisch dadurch in besonders einfacher Weise verwirklicht werden, daß der Lichtquellenhalter mit einem Zwischenhebel verkoppelt ist, an dessen eines Ende die Kniegelenkhebel-Anordnung des ersten optischen Elements und dessen anderes Ende mit der Kniehebel-Anordnung des zweiten optischen Elements verkoppelt ist. Die Kniegelenkhebel sind so angeordnet, daß sie bei senkrechtem Auftreffen des Projektionslichtstrahls auf die Mitte der ebenen Projektionsfläche bzw. Montagefläche völlig gestreckt sind und somit die Punktlichtquelle (Lochblende) in der größtmöglichen Entfernung von der Abbildungslinse bzw. -Linsengruppe halten. Jede Auslenkung aus dieser Position durch Drehung eines oder beider Spiegel in beliebiger Richtung verkürzt die Entfernung zwischen den Spiegelachsen und dem Zwischenhebel und damit den Abstand zwischen Punktlichtquelle und Abbildungslinse oder -Linsengruppe. Diese Reduzierung des Objektabstands führt zu einer Vergrößerung des Bildabstands, so daß der Leuchtpunkt nunmehr in größerer Entfernung von der Abbildungslinse oder -Linsengruppe (Objektiv) scharf abgebildet wird - dies ist auch erforderlich, da, wie bereits erwähnt, mit jeder Auslenkung auch der Abstand zwischen dem auf die Montagefläche projizierten Leuchtpunkt und dem Objektiv größer wird.

Man erspart sich eine aufwendige Linearführung für die Auslenkbewegung des Trägerteils in Richtung der optischen Achse, wenn diese in einer Weiterbildung der Erfindung am Trägerteil schwenkbar angebracht ist, vorzugsweise über eine Blattfeder. Der Lichtquellenhalter wird in Ruhelage senkrecht zur optischen Achse ausgerichtet sein. Die bei der Schwenkbewegung aus dieser Lage auftretende Bewegungskomponente der punktförmigen Lichtquelle senkrecht zur optischen Achse kann wegen des kurzen Bewegungswegs in Richtung der optischen Achse bereits bei geringen Hebellängen vernachlässigt werden.

Es wird vorgeschlagen, daß der Lichtquellenhalter mit dem Zwischenhebel über ein Schwenkgelenk im Bereich zwischen den beiden Enden des Zwischenhebels verbunden ist. Hierbei kann vorgesehen sein, daß die beiden Kniegelenkhebel-Anordnungen mit dem Zwischenhebel jeweils gelenkig verbunden sind. Diese Bauform ist bei zuverlässiger Funktion einfach herzustellen, da lediglich Gelenke auszubilden sind. Die skalare Addition der Auslenkwerte ist gewährleistet.

Um mit hoher Genauigkeit bei baulich einfachem Aufwand die Schwenkwinkeleinstellung des jeweiligen optischen Elements vornehmen zu können, wird zusätzlich oder auch unabhängig von der vorstehend beschriebenen Lösung vorgeschlagen, daß das wenigstens eine schwenkbare optische Element mit einem Schlepphebel verkoppelt ist, daß der Schlepphebel einen Nockenvorsprung aufweist, und daß der Nockenvorsprung an eine Nockenfläche einer motorgetriebenen Antriebsscheibe angreift. Um ein hohes Untersetzungsverhältnis zu erhalten, wird vorgeschlagen, daß die Antriebsscheibe mit einer Nockenfläche bildenden Spiral-Nut versehen ist.

Zur einfachen Verbindung der Antriebsscheibe mit einem Antriebsmotor, vorzugsweise Schrittmotor, wird vorgeschlagen, daß die Antriebsscheibe über einen Riemenantrieb mit einem Antriebsmotor verbunden ist.

Aufgrund der erzielbaren hohen Untersetzung kann der Schlepphebel starr mit dem schwenkbaren optischen Element, insbesondere Spiegel, verbunden sein, was wiederum zum einfachen Aufbau beiträgt. Es können kleine und preiswerte Schrittmotoren verwendet werden mit geringer Schrittzahl je Umdrehung - dennoch erhält man aufgrund des hohen Übersetzungsverhältnisses eine sehr kleine, praktisch nicht mehr sichtbare Schrittweite des auf der Montagefläche projizierten Leuchtpunkts.

Ferner wird vorgeschlagen, daß der schwenkbar gelagerte Schlepphebel mittels eines Federelements in eine der beiden Schwenkrichtungen federvorgespannt ist. Durch diese einfache Maßnahme wird stets ein spielfreier Andruck des Nocken-Vorsprungs an die Nocken-Fläche gewährleistet, wobei der Nocken-Vorsprung innerhalb der Spiral-Nut durchaus Spiel haben kann, was Leichtgängigkeit des Nocken-Vorsprungs innerhalb der Spiral-Nut sicherstellt; die Spiral-Nut muß nicht derart präzise gefertigt sein, daß der Nocken-Vorsprung im wesentlichen spielfrei in der Spiral-Nut läuft.

Es kann ein vom Schlepphebel betätigbarer Endschalter vorgesehen sein, um auf diese Weise ein Abschalten des Antriebsmotors bei Überschreiten vorgegebener Grenz-Schwenkwinkel zu erreichen.

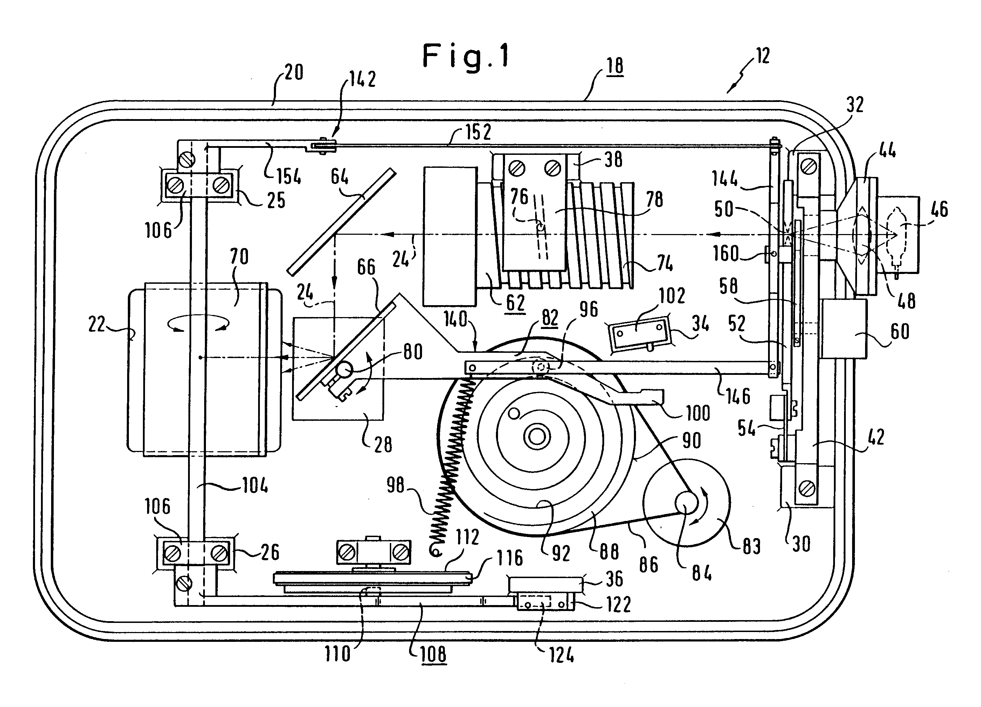

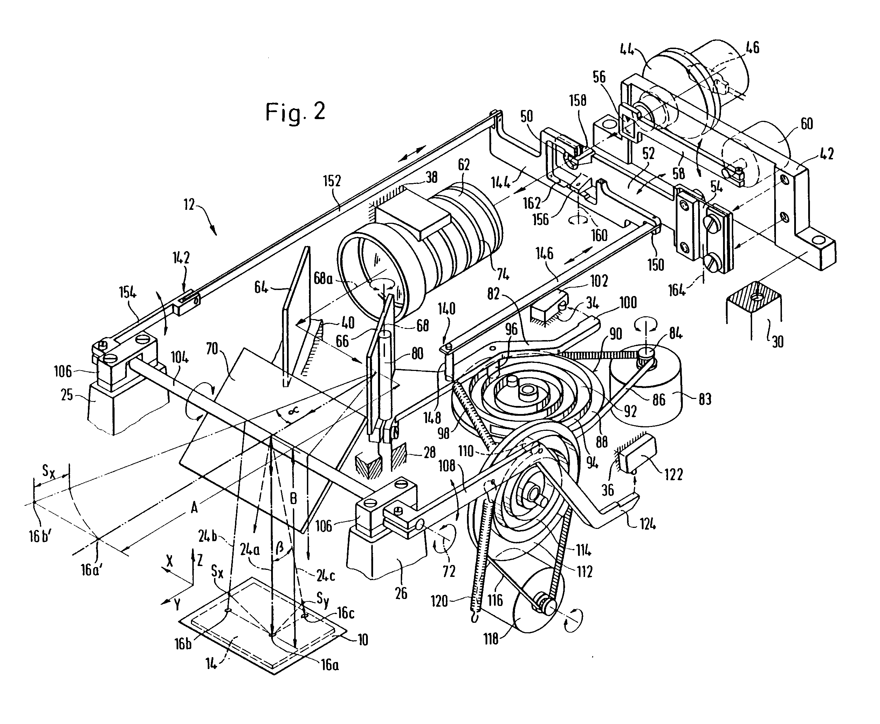

Die Erfindung wird im folgenden an Hand der Figuren 1 und 2 beispielshaft erläutert.
Es zeigt:

Fig. 1 eine vereinfachte Draufsicht auf einen erfindungsgemäßen Projektionskopf mit abgenommenem Gehäusedeckel und

Fig. 2 eine isometrische Prinzipzeichnung wesentlicher Bauelemente des Projektionskopfs.

Der in den Figuren vereinfacht dargestellte Projektionskopf kann Teil eines Bestückungstisches sein, wie dieser beispielsweise in der DE-A-27 16 548 beschrieben ist. Der mit Abstand von einer Montagefläche (in Fig. 2 links unten angedeutet) oberhalb dieser Fläche 10 angeordnete Projektionskopf 12 dient dazu, auf der Montagefläche 10 bzw. auf einer auf der Montagefläche aufgelegten Schaltungsplatine 14 einen Leuchtpunkt 16 zu projizieren als Hinweis für eine am Bestückungstisch arbeitende Person, daß dort das nunmehr an der Reihe befindliche, anderweitig bereitgestellte elektronische Bauteil anzubringen ist. Die erfindungsgemäße Anordnung ist jedoch auch in anderen Fällen einsetzbar, bei welchen es auf eine umrißscharfe Abbildung eines Leuchtpunkts oder ähnlichen elementaren Leuchtgebildes, wie z.B. Kreis, Kreuz, Pfeil oder dergl., auf eine relativ große Fläche in unterschiedlichen Leuchtpunktpositionen ankommt.

Der Projektionskopf 12 weist ein angenähert plattenförmiges Trägerteil 18 auf mit seitlich hochgezogenem, abgestuftem Rand 20 zum Aufsetzen einer in den Figuren weggelassenen Positionskopf-Haube. Das Trägerteil 18 ist mit einer rechteckigen Öffnung 22 versehen, durch welche hindurch der im Projektionskopf 12 erzeugte Lichtstrahl 24 vertikal nach unten verläuft, bis er auf die Fläche 10 auftrifft. In den Figuren 1 und 2 angedeutete Befestigungssockel 25,26,28,30,32,34,36,38 und 40 zur Befestigung innerer Bauteile des Projektionskopfes 12 sind einstückig mit dem Trägerteil 18 ausgebildet.

An den Sockeln 30 und 32 ist eine Brücke 42 starr angebracht, welche ein Lampengehäuse 44 trägt. Innerhalb des Lampengehäuses 44 ist eine Beleuchtungsquelle in Form beispielsweise eines Halogen-Lämpchens 46 vorgesehen sowie eine in Fig. 1 strichliert angedeutete Sammellinse 48, die die vom Lämpchen 46 ausgehenden Strahlen auf das Blendenloch einer Lochblende 50 konzentrieren. Der Durchmesser der Sammellinse (Kondensorlinse) 48 ist derart festgelegt, daß der vom Blendenteil ausgehende Lichtkegel die Eintrittsöffnung eines nachfolgenden Objektivs 62 voll ausleuchtet, um möglichst große Helligkeit des Leuchtpunkts auf der Montagefläche 10 zu erhalten. Die Lochblende 50 ist an einem armartigen Lichtquellen-Halter 52 ausgebildet, insbesondere durch Anfertigung einer entsprechend feinen Durchgangsbohrung im Trägerteil 52. Der Trägerteil 52 ist über eine als Schwenkgelenk mit vertikaler Drehachse dienende Blattfeder 54 an der Brükke 42 befestigt.

Um wahlweise einen farbigen Lichtstrahl zu erhalten, kann in den Strahlengang zwischen Lämpchen 46 und Lochblende 50 ein Farbfilterplättchen 56 am freien Ende eines schwenkbar gelagerten und über einen Elektromotor 60 angetriebenen Arms 58 geschwenkt werden.

Das rückwärtig durch das Lämpchen 46 beleuchtete Loch der Lochblende 50 bildet eine angenähert punktförmige, divergentes Licht aussendende Lichtquelle, die über das Abbildungs-Objektiv 62, einen stationären Spiegel 64, dann über einen ersten Schenkspiegel 66 mit vertikaler Schwenkachse 68 sowie schließlich über einen zweiten Schwenkspiegel 70 mit horizontaler Schwenkachse 72 auf die Montagefläche 10 bzw. auf eine auf der Fläche 10 ruhende Schaltungsplatine 14 randscharf projiziert wird. Die Schwenkachsen 68 und 72 liegen also windschief und rechtwinkelig zueinander. Der Leuchtpunkt 16 ist daher das Bild des das Objekt bildenden Lochs der rückwärtig beleuchteten Lochblende 50. In der dargestellten Anordnung läuft der Lichtstrahl 24 von der Lochblende 50 ausgehend in einer im wesentlichen horizontalen Ebene parallel zur Fläche 10 durch das Objektiv 62, wobei er anschließend über den in vertikaler Ebene angeordneten Spiegel 64 um 90° abgelenkt und auf das Zentrum des schwenkbaren Spiegels 66 gelenkt wird. In der dargestellten Neutralstellung des ersten Schwenkspiegels 66, in der der Schwenkspiegel 66 parallel zum Spiegel 64 angeordnet ist, wird der Lichtstrahl daher in der Horizontalebene um 90° abgelenkt, so daß er wieder parallel zur optischen Achse 68a des Objektivs 68 verläuft und anschließend auf den Spiegel 70 trifft. Dieser lenkt ihn in der ebenfalls dargestellten Neutralstellung um 90° nach unten ab, so daß er senkrecht auf die Mitte der Montagefläche 10 trifft, wo er als vergrößertes Abbild der Leuchtpunktblende bzw. Lochblende 50 sichtbar wird. Wird der Spiegel 66 oder der Spiegel 70 aus der jeweiligen Neutralstellung verschwenkt, so wandert der Leuchtpunkt auf der Montagefläche 10 in X-Richtung bzw. in Y-Richtung, so daß jeder Ort der Montagefläche 10 durch Einstellen eines ihm jeweils zugeordneten Schwenkwinkelpaars für die Schwenkspiegel 66 und 70 erreichbar ist. Jedem Ort der Montagefläche ist also ein derartiges Schwenkwinkelpaar in eindeutiger Weise zugeordnet.

Das Objektiv 62 ist am Befestigungssockel 38 montiert. Zur einmaligen Scharfeinstellung entsprechend dem Abstand zwischen dem Projektionskopf und der Fläche 10 bzw. des auf der Fläche liegenden zu bestückenden Gegenstands, ist das Objektiv 62 in Richtung seiner optischen Achse verstellbar ausgebildet. Hierzu kann das Objektiv mit einer äußeren Umfangs-Spiralnut 74 versehen sein, in die ein am Befestigungssockel vorstehender Führungsstift 76 eingreift. Eine in Fig. 1 erkennbare gewölbte Blattfeder 78 drückt den Außenumfang des Objektivs 62 gegen die entsprechende Auflagefläche des Befestigungssockels 38.

Der Schwenkspiegel 66 mit vertikaler Drehachse 68 ist an einer am Sockel 28 befestigten Welle 80 schwenkbar gelagert. Er ist starr verbunden mit einem Schlepphebel 82, der von einem Elektromotor, insbesondere Schrittmotor 83, um die Achse 68 wahlweise verschwenkt werden kann. Hierzu ist eine Antriebswelle 84 des Elektromotors 83 über einen Zahnriemen 86 mit einer Antriebsscheibe 88 verbunden, wobei der Zahnriemen 86 der Einfachheit halber auf dem entsprechend der Verzahnung des Zahnriemens 86 gerippten Außenumfang 90 der Zahnscheibe 88 läuft.

Die Antriebsscheibe 88 ist mit einem eine Spiral-Nut 92 bildenden Steg 94 ausgebildet. In diese Spiral-Nut greift ein vom Schlepphebel 82 nach unten vorspringender Nocken-Vorsprung 96, insbesondere in Form einer Nocken-Rolle, ein. Eine Spiral-Zugfeder 98 spannt den Schlepphebel 82 im Uhrzeigersinn der Figuren 1 und 2 vor, so daß der Nocken-Vorsprung 96 stets an einer Flanke in Fig. 1 der oberen Flanke) der Spiral-Nut 92 spielfrei anliegt.

Das freie Ende 100 des Schlepphebels 82 dient der Betätigung eines am Sockel 34 vorgesehenen End-Schalters 102 in einer der beiden Endstellungen des Schwenkhebels 82.

Der zweite Schwenkspiegel 70 ist an einer horizontal verlaufenden Schwenkwelle 104 starr angebracht ist. Die beiden Enden der Schwenkwelle 104 sind über jeweils ein Schwenklager 106 an den beiden Sockeln 25 und 26 um die Achse 72 drehbar gelagert. Zur Verschwenkung des Schwenkspiegels 70 ist die Welle 104 mit einem Schlepphebel 108 starr verbunden, der wiederum mit einem Nocken-Vorsprung 110 in Form einer Nocken-Rolle in eine an einer zweiten Antriebsscheibe 112 ausgebildete Spiral-Nut 114 eingreift. Die Antriebsscheibe 112 kann wiederum über einen Zahnriemen 116 durch einen Elektromotor, insbesondere Schrittmotor 118, wahlweise in der einen oder anderen Richtung angetrieben werden. Hierzu sind natürlich die beteiligten Schwenk- bzw. Drehachsen der Welle 104, der Antriebsscheibe 112 sowie des Elektromotors 118 parallel zueinander angeordnet.

Auch hier sorgt eine Schrauben-Zugfeder 120 für eine spielfreie Anlage des Nocken-Vorsprungs 110 an einer Flanke der Spiral-Nut 114. Ein am Sockel 36 befestigter Endschalter 122 wird in einer der beiden End-Schwenkstellungen des Schlepphebels 108 vom freien Hebelende 124 betätigt.

Die beiden Endschalter 102 und 122 melden eine bekannte Position der jeweiligen Schlepphebel 82;108, welche als Referenz zum Auffinden beliebiger Leuchtpunktorte auf der Montagefläche 10 dient.

Wesentlich für die Anwendung des Projektionskopfes ist es, daß der Leuchtpunkt 16 in sämtlichen möglichen Positionen auf der Fläche 10 bzw. der zu bestückenden Schaltungsplatine 14 randscharf und nicht verschwommen erscheint. Bei der vorliegenden Anordnung mit Schwenkspiegeln ändert sich jedoch die Länge der Lichtstrahl-Laufstrecke zwischen Lochblende 50 und Fläche 10 bzw. Schaltungsplatine 14 bei Veränderung der Leuchtpunktposition. Betrachtet man beispielsweise den in Fig. 2 mit verstärkter Strich-Punkt-Linie angedeuteten Strahl 24a, den man in der Neutralstellung der beiden Schwenkspiegel 66 und 70 erhält, so trifft dieser den Punkt 16a auf die Fläche 10. Wird anschließend der Schwenkspiegel 66 um den Winkel $\alpha$ verschwenkt, so verlagert sich der Leuchtpunkt auf der Fläche vom Punkt 16a in Richtung X zum Punkt 16b. Zur Vereinfachung der Ableitung des Strahl-Wegunterschieds ist in Fig. 2 jeweils mit einer Strich-Punkt-Punktlinie der gerade Strahlverlauf bei Weglassen des Schwenkspiegels 70 angedeutet. Der Endpunkt 16a' des Neutralstrahls 24a (Umlenkwinkel 90° durch den Schwenkspiegel 66) hat einen Abstand A vom Auftreffpunkt des Strahls aus dem Schwenkspiegel 66, welcher der Summe der Laufstrecke des Strahls 24a zwischen Schwenkspiegel 66 und Schwenkspiegel 70 und zwischen Schwenkspiegel 70 und Fläche 10 entspricht. Der Laufwegunterschied zwischen dem Strahl 24a und dem um den Winkel $\alpha$ abgelenkten Strahl 24b ist Fig. 2 mit $S_x$ bezeichnet und hat den folgenden Wert:

$$S_x = A \left( \frac{1}{\cos \alpha} - 1 \right) .$$

Man erhält daher beim Verschwenken des Schwenkspiegels 60 eine "Bildfeldwölbung" in der X, Z-Ebene längs eines Kreisbogens mit Radius A.

Beim Verschwenken des Schwenkspiegels 70 ergibt sich eine dementsprechende "Bildfeldwölbung" in der Y, Z-Ebene entlang eines Kreisbogens mit einem dem Abstand B zwischen dem Strahlauftreffpunkt auf dem Schwenkspiegel 70 und der Fläche 10 entsprechenden Radius. Der entsprechende Weglängenunterschied zwischen Neutral-Strahl 24a und dem um den Winkel $\beta$ vom Spiegel 70 abgelenkten Strahl 24c mit Auftreffpunkt 16c auf der Fläche 10 ist in Fig. 2 mit $S_y$ bezeichnet und hat folgenden Wert:

$$S_y = B \left( \frac{1}{\cos \beta} - 1 \right)$$

Da B ungleich A ist, ergibt sich eine nicht rotationssymmetrische "Bildfeldwölbung", sobald beide Winkel $\alpha$ und $\beta$ variiert werden.

Um dennoch eine scharfe Abbildung der Punktlichtquelle auf de gesamten Fläche 10 bzw. auf der Schaltungsplatine 14 zu erhalten, wird der Abstand der Lochblende 50 vom Objektiv 62, d.h. die Gegenstandsweite, in Abhängigkeit von den Schwenkwinkeln der beiden Spiegel 66 und 70 und somit in Abhängigkeit von der die jeweilige effektive Bildweite darstellenden Weglänge des Strahls 24 zwischen Objektiv und Fläche 10 geändert.

Hierzu sind beide Schwenkspiegel 66 und 70 jeweils über eine Kniegelenkhebel-Anordnung 140 bzw. 142 mit einem Zwischenhebel 144 verbunden, welcher wiederum an den Lichtquellen-Halter 52 angreift.

Die Kniegelenkhebel-Anordnung 140 wird zum einen vom Zwischenhebel 144 gebildet und zum anderen von einem Verbindungsarm 146, dessen eines Ende über einen vertikalen Gelenkzapfen 148 mit dem Schlepphebel 82 verbunden ist (Kniegelenk) und dessen anderes Ende an ein Ende des länglichen Zwischenhebels 144 ebenfalls über ein Schwenkgelenk 150 angreift.

Der längliche Zwischenhebel 144 ist in horizontaler Ebene liegend quer zur Achse 68a des Objektivs 62 angeordnet. Sein anderes Ende ist gelenkig mit einem Ende eines Verbindungsarms 152 verbunden, dessen anderes Ende wiederum gelenkig mit einem an der Welle 104 drehfest angebrachten Hebearm 154 gelenkig angreift. Die Gelenkachsen des Verbindungsarms 152 an seinen beiden Enden verlaufen parallel zur Achse 72 der Welle 104.

In einem mittleren Bereich des Zwischenhebels 144 ist dieser über Gelenkvorsprünge 156,158 mit vertikaler Drehachse 160 mit dem Lichtquellen-Halter 52 gelenkig verbunden. Eine in Fig. 2 angeordnete Aussparung 162 im Zwischenhebel 144 gestattet den ungehinderten Durchtritt des vom Loch der Lochblende 50 ausgehenden Lichtes in Richtung zur Eintrittspupille des Objektivs 62. Der Zwischenhebel 144 dient als mechanisches Additionsglied für die durch die beiden Kniehebel-Anordnungen 140 und 142 hervorgerufenen Auslenkungen.

Wird beispielsweise lediglich die Kniegelenkhebel-Anordnung 142 verstellt, so verschwenkt der Zwischenhebel 144 dementsprechend um das Schwenkgelenk 150. Entsprechend dem Verhältnis der Abstände zwischen der Schwenkachse 160 und der beiden Enden des Zwischenhebels 144 führt die Verlagerung des in Fig. 2 linken Endes des Zwischenhebels 144 um den Auslenkwert W zu einer Verlagerung der Schwenkachse 60 und damit des Lichtquellenhalters 52 samt Lochblende 50 um einen entsprechend reduzierten Wert, und zwar hauptsächlich in Richtung der optischen Achse (falls die Schwenkachse 160 sich in der Längenmitte des Zwischenhebels 144 befindet, so ist dessen Verlagerung gleich der Hälfte des Auslenkwerts W).

Wird zusätzlich die Kniegelenkhebel-Anordnung 140 verstellt, so erhält man eine dementsprechende Schwenkbewegung des Zwischenhebels 144 um das in Fig. 2 links oben gelegene Hebelende mit entsprechender Verlagerung der Lochblende 50. Das Ergebnis ist eine Verlagerung der Lochblende 50 in Richtung der optischen Achse um einen Wert, der einer gewichteten Summe der Auslenkwerte der beiden Kniegelenkhebel-Anordnungen 140 und 142 entspricht.

Wird nun beispielsweise der Schwenkspiegel 66 aus seiner in Fig. 2 dargestellten Neutralstellung mit 90°-Umlenkung des Lichtstrahls 24 in der einen oder anderen Richtung verschwenkt, so wird das in der Neutralstellung gestreckte Kniegelenk der Gelenkanordnung 140 (Schwenkachsen zwischen den Teilen 144,146;82 und 80 miteinander fluchtend) in der entsprechenden Richtung abgebogen, was dazu führt, daß das Schwenkgelenk 150 zwischen dem Arm 146 und dem Zwischenhebel 144 sich der Schwenkachse 68 des Spiegels 66 zunehmend nähert. In der Folge kommt es zu einer entsprechenden Schwerkbewegung des Lichtquellen-Halters 52 um seine durch die Blattfeder 54 gebildete Schwenkachse 164 im Gegenuhrzeigersinn der Figuren 1 und 2. Dementsprechend reduziert sich die Gegenstandsweite. Nach den Abbildungsgesetzen hat dies eine entsprechende Vergrößerung der Bildweite zur Folge, so daß die Verlängerung des Strahlwegs auf der Bildseite aufgrund Verschwenken des Spiegels 66 kompensiert werden kann. Ist demnach der vom Strahl 24a erzeugte Leuchtpunkt 16a scharf eingestellt, so ist auch der Leuchtpunkt 16b nach Verschwenken des Spiegels 66 scharf.

In entsprechender Weise führt auch eine Schwenkbewegung des Spiegels 70 aus seiner in der Fig. 2 dargestellten Neutralstellung mit 90°-Umlenkung vertikal nach unten und gestrecktem Kniegelenk der Kniegelenkhebel-Anordnung 142 zu einem Abknicken des Kniegelenks und in der Folge zu einem Verschwenken des Zwischenhebels 144 um sein vom Verbindungshebel 152 entferntes Ende im Gegenuhrzeigersinn der Fig. 2. Der Lichtquellen-Halter 52 verschwenkt daraufhin ebenfalls im Gegenuhrzeigersinn der Fig. 2 mit entsprechender Reduzierung der Gegenstandsweite. Durch entsprechende Festlegung der Hebellängen der Kniegelenkhebel-Anordnung 142 sowie des Verhältnisses der Abstände zwischen der Schwenkachse 160 und dem einen bzw. anderen Ende des Zwischenhebels 144 läßt sich, für jede Auslenkrichtung X bzw. Y getrennt betrachtet, in erster Näherung eine mathematisch exakte Schärfe-Nachstellung erreichen. Bei gleichzeitiger Auslenkung des Leuchtpunktes in X- und Y-Richtung ergibt sich wegen der skalaren Summenbildung der X-Y-Verstellwege über den Zwischenhebel 144 zwar keine mathematisch exakte Schärfennachstellung mehr, jedoch ist die vorstehend beschriebene, baulich besonders einfach zu realisierende Lösung ausreichend, um z.B. bei einem Positionskopfabstand von 1 Meter zur Montagefläche 10 die Schärfe des Leuchtpunkts innerhalb einer Fläche von 0,6 x 0,6 m ausreichend exakt nachzustellen.

**Patentansprüche**

1. Projektionskopf für einen Leuchtpunkt (16) auf einer Fläche (10), insbesondere einer Montagefläche eines Bestückungstisches zur Bestückungs-Ortsanzeige, mit
   - einem Trägerteil (18),
   - einer Punktlichtquelle, insbesondere in Form einer rückwärtig beleuchteten Lochblende (50),
   - einem am Trägerteil (18) beweglich angeordneten Halter (52) für die Punktlichtquelle und
   - einer am Trägerteil (18) angeordneten Abbildungsoptik zur Abbildung der Punktlichtquelle als Leuchtpunkt (16) auf die Fläche (10) mit wenigstens einem am Trägerteil (18) beweglich angebrachten optischen Element zur wahlweisen Verlagerung des Leuchtpunkts (16) auf der Fläche (10),
   dadurch **gekennzeichnet,**
   - daß die Abbildungsoptik eine am Trägerteil (18) ortsfest angebrachte Abbildungslinse oder -Linsengruppe (62) umfaßt,
   - daß das wenigstens eine optische Element am Trägerteil (18) schwenkbar gelagert ist, und
   - daß der Lichtquellen-Halter (52) samt Punktlichtquelle gegenüber der Abbildungslinse oder -Linsengruppe in Richtung der optischen Achse in Abhängigheit vom jeweiligen Schwenkwinkel des wenigstens einen optischen Elements auslenkbar ausgebildet ist.

2. Projektionskopf nach Anspruch 1, dadurch **gekennzeichnet,** daß bei Einsatz eines ersten schwenkbeweglichen optischen Elements, vorzugsweise Schwenkspiegels (70), mit einer ersten Schwenkachse (72) und eines zweiten schwenkbeweglichen optischen Elements, vorzugsweise Schwenkspiegels (66), mit einer zur ersten Schwenkachse (72) senkrechten zweiten Schwenkachse (68) jedem Schwenkwinkel des ersten optischen Elements jeweils ein erster Auslenkwert und jedem Schwenkwinkel des zweiten optischen Elements jeweils ein zweiter Auslenkwert zugeordnet ist, und daß die Auslenkung der Punktlichtquelle vom jeweiligen ersten und zweiten Auslenkwert abhängig ist.

**3.** Projektionskopf nach Anspruch 2,
dadurch **gekennzeichnet**,
daß die Auslenkung der Punktlichtquelle von einem Summenwert des jeweiligen ersten und zweiten Auslenkwerts abgeleitet ist.

**4.** Projektionskopf nach Anspruch 2 oder 3,
**gekennzeichnet** durch wenigstens eine Hebelanordnung (140,142,144) zur Umsetzung der Schwenkbewegung des wenigstens einen optischen Elements in eine entsprechende Auslenkbewegung der Punktlichtquelle.

**5.** Projektionskopf nach Anspruch 4,
dadurch **gekennzeichnet,**
daß der Lichtquellenhalter (52) jeweils über eine Kniegelenkhebel-Anordnung (140,142) mit zur Schwenkachse des jeweiligen optischen Elements paralleler Kniegelenkachse mit dem wenigstens einen schwenkbeweglichen optischen Element verbunden ist.

**6.** Projektionskopf nach Anspruch 5,
dadurch **gekennzeichnet,**
daß der Lichtquellenhalter (52) mit einem Zwischenhebel (144) verkoppelt ist, dessen eines Ende mit der Kniegelenkhebel-Anordnung (142) des ersten optischen Elements und dessen anderes Ende mit der Kniegelenkhebel-Anordnung (140) des zweiten optischen Elements verkoppelt ist.

**7.** Projektionskopf nach Anspruch 6,
dadurch **gekennzeichnet,**
daß der Lichtquellenhalter (52) mit dem Zwischenhebel (144) über ein Schwenkgelenk im Bereich zwischen den beiden Enden des Zwischenhebels (144) verbunden ist.

**8.** Projektionskopf nach Anspruch 6 oder 7,
dadurch **gekennzeichnet,**
daß die beiden Kniegelenkhebel-Anordnungen (140,142) mit dem Zwischenhebel (144) jeweils gelenkig verbunden sind.

**9.** Projektionskopf nach einem der vorhergehenden Ansprüche,
dadurch **gekennzeichnet,**
daß der Lichtquellenhalter (52) am Trägerteil (18) schwenkbar angebracht ist.

**10.** Projektionskopf nach Anspruch 9,
dadurch **gekennzeichnet,**
daß der Lichtquellenhalter (52) mit dem Trägerteil (18) über eine Blattfeder (54) verbunden ist.

**11.** Projektionskopf nach einem der vorhergehenden Ansprüche oder dem Oberbegriff des Anspruchs 1,
dadurch **gekennzeichnet,**
daß das wenigstens eine schwenkbare optische Element mit einem Schlepphebel (82;108) verkoppelt ist, daß der Schlepphebel (82;108) einen Nockenvorsprung (96;110) aufweist, und daß der Nockenvorsprung (96;110) an eine Nockenfläche einer motorgetriebenen Antriebsscheibe (88;112) angreift.

**12.** Projektionskopf nach Anspruch 11,
dadurch **gekennzeichnet,**
daß die Antriebsscheibe (88;112) mit einer die Nockenfläche bildenden Spiral-Nut (92;114) versehen ist.

**13.** Projektionskopf nach Anspruch 11 oder 12,
dadurch **gekennzeichnet,**
daß die Antriebsscheibe (88;112) über einen Riemenantrieb mit einem Antriebsmotor (83;118) verbunden ist.

**14.** Projektionskopf nach einem der Ansprüche 11 bis 13,
dadurch **gekennzeichnet,**
daß der Schlepphebel (82;108) starr mit dem schwenkbaren optischen Element verbunden ist.

**15.** Projektionskopf nach einem der Ansprüche 11 bis 14,
dadurch **gekennzeichnet,**
daß der schwenkbar gelagerte Schlepphebel (82;108) mittels eines Federelements (98;120) in eine der beiden Schwenkrichtungen federvorgespannt ist.

**16.** Projektionskopf nach einem der Ansprüche 11 bis 15,
**gekennzeichnet** durch
einen vom Schlepphebel (82;108) betätigbaren Endschalter (102,122).

**Claims**

**1.** Projection head for projecting a light point (16) on a surface (10), particularly on an assembly surface of an assembly table for indicating the location for assembly, including

- a carrier part (18),
- a point light source, particularly in the form of a pin diaphragm (50) which is illuminated from the rear,
- a holder (52) for the point light source, which holder (52) is arranged at the carrier part (18) so as to be movable, and

- imaging optics arranged at the carrier part (18) for imaging the point light source as light point (16) on the surface (10) with at least one optical element which is movably attached to the carrier part (18) for shifting the light point (16) on the surface (10), as desired,

characterized in that

- the imaging optics include an imaging lens or lens group (62) which is attached at the carrier part (18) so as to be stationary,
- the optical element, of which there is at least one, is supported at the carrier part (18) so as to be swivelable, and
- the light source holder (52), including the point light source, is constructed in such a way that it can be deflected relative to the imaging lens or lens group in the direction of the optical axis as a function of the respective swivel angle of the optical element, of which there is at least one.

2. Projection head according to claim 1, characterized in that when using a first swivelably movable optical element, preferably a swivel mirror (70), having a first swivel axis (72) and a second swivelably movable optical element, preferably swivel mirror (66), having a second swivel axis (68) vertical to the first swivel axis (72), a first deflecting value is assigned to every swivel angle of the first optical element and a second deflecting value is assigned to every swivel angle of the second optical element, and in that the deflection of the point light source is a function of the respective first and second deflecting values.

3. Projection head according to claim 2, characterized in that the deflection of the point light source is derived from a sum of the respective first and second deflecting values.

4. Projection head according to claim 2 or 3, characterized by at least one lever arrangement (140, 142, 144) for transforming the swiveling movement of the optical element, of which there is at least one, into a corresponding deflecting movement of the point light source.

5. Projection head according to claim 4, characterized in that the light source holder (52) is connected in each instance with the swivelably movable optical element, of which there is at least one, via a knee joint lever arrangement (140, 142), the axis of articulation of the knee joint being parallel to the swivel axis of the respective optical element.

6. Projection head according to claim 5, characterized in that the light source holder (52) is coupled with an intermediate lever (144), the knee joint lever arrangement (142) of the first optical element being coupled at one end of the intermediate lever (144) and its other end being coupled with the knee joint lever arrangement (140) of the second optical element.

7. Projection head according to claim 6, characterized in that the light source holder (52) is connected with the intermediate lever (144) via a swivel joint in the area between the two ends of the intermediate lever (144).

8. Projection head according to claim 6 or 7, characterized in that the two knee joint lever arrangements (140, 142) are connected in an articulated manner in each instance with the intermediate lever (144).

9. Projection head according to one of the preceding claims, characterized in that the light source holder (52) is arranged at the carrier part (18) so as to be swivelable.

10. Projection head according to claim 9, characterized in that the light source holder (52) is connected with the carrier part (18) via a leaf spring (54).

11. Projection head according to one of the preceding claims or according to the preamble of claim 1, characterized in that the swivelable optical element, of which there is at least one, is coupled with a drag lever (82;108), in that the drag lever (82;108) comprises a cam projection (96;110), and in that the cam projection (96;110) acts at a cam surface of a motor-driven drive pulley (88;112).

12. Projection head according to claim 11, characterized in that the drive pulley (88;112) is provided with a helical groove (92; 114) forming the cam surface.

13. Projection head according to claim 11 or 12, characterized in that the drive pulley (88;112) is connected with a drive motor (83;118) via a belt drive.

14. Projection head according to one of claims 11 to 13, characterized in that the drag lever (82; 108) is rigidly connected with the swivelable optical element.

**15.** Projection head according to one of claims 11 to 14, characterized in that the swivelably supported drag lever (82; 108) is pretensioned in one of the two swiveling directions by means of a spring element (98; 120).

**16.** Projection head according to one of claims 11 to 15, characterized by a limit switch (102, 122) which can be actuated by the drag lever (82; 108).

**Revendications**

**1.** Tête de projection pour un point lumineux (16) sur une surface (10), en particulier une surface de montage d'une table d'équipement en vue de l'indication de l'emplacement de l'équipement, comportant
   - un élément porteur (18),
   - une source lumineuse ponctuelle, en particulier sous la forme d'un diaphragme (50) éclairé de l'arrière,
   - un support (52), monté mobile sur l'élément porteur (18), pour la source lumineuse ponctuelle et
   - une optique de reproduction, placée sur l'élément porteur (18), pour reproduire la source lumineuse ponctuelle sous la forme d'un point lumineux (16) sur la surface (10), présentant au moins un élément optique, monté mobile sur l'élément porteur (18), afin de déplacer au choix le point lumineux (16) sur la surface (10), caractérisée en ce que
   - l'optique de reproduction comporte une lentille ou un groupe de lentilles de reproduction (62), monté fixe sur l'élément porteur (18),
   - l'élément optique, au nombre d'au moins un, est monté pivotant sur l'élément porteur (18) et
   - le support de source lumineuse (52) avec la source lumineuse ponctuelle peut être dévié par rapport à la lentille ou au groupe de lentilles de reproduction, en direction de l'axe optique, en fonction de l'angle de pivotement d'au moins un élément optique.

**2.** Tête de projection selon la revendication 1, caractérisée en ce que dans le cas où l'on utilise un premier élément optique pivotant, de préférence un miroir pivotant (70), avec un premier axe de pivotement (72) et un deuxième élément optique pivotant, de préférence un miroir pivotant (66), avec un deuxième axe de pivotement (68), perpendiculaire au premier axe de pivotement (72), il est associé à chaque angle de pivotement du premier élément optique une première valeur de déviation et à chaque angle de pivotement du deuxième élément optique, une deuxième valeur de déviation et en ce que la déviation de la source lumineuse ponctuelle dépend de la première et de la deuxième valeur de déviation.

**3.** Tête de projection selon la revendication 2, caractérisée en ce que la déviation de la source lumineuse ponctuelle est dérivée d'une somme de la première et de la deuxième valeur de déviation.

**4.** Tête de projection selon les revendications 2 ou 3 caractérisée par au moins un dispositif à levier (140, 142, 144) destiné à convertir le pivotement d'au moins un élément optique en une déviation correspondante de la source lumineuse ponctuelle.

**5.** Tête de projection selon la revendication 4, caractérisée en ce que le support de source lumineuse (52) est relié avec l'élément optique pivotant au nombre d'au moins un, par un dispositif à levier à genouillère (140, 142) dont l'axe de la genouillère est parallèle à l'axe de pivotement de l'élément optique correspondant.

**6.** Tête de projection selon la revendication 5, caractérisée en ce que le support de source lumineuse (52) est couplé à un levier intermédiaire (144) dont une extrémité est couplée avec le dispositif à levier à genouillère (142) du premier élément optique et dont l'autre extrémité est couplée avec le dispositif à levier à genouillère (140) du deuxième élément optique.

**7.** Tête de projection selon la revendication 6, caractérisée en ce que le support de source lumineuse (52) est relié au levier intermédiaire (144), par une articulation de pivotement, dans la zone comprise entre les deux extrémités du levier intermédiaire (144).

**8.** Tête de projection selon la revendication 6 ou 7, caractérisée en ce que les deux dispositifs à levier à genouillère (140, 142) sont reliés chacun par articulation avec le levier intermédiaire (144).

**9.** Tête de projection selon l'une des revendications précédentes, caractérisée en ce que le support de source lumineuse (52) est monté pivotant sur l'élément porteur (18).

**10.** Tête de projection selon la revendication 9, caractérisée en ce que le support de source lumineuse (52) est relié à l'élément porteur (18) par un ressort à lame (54).

**11.** Tête de projection selon l'une des revendications précédentes ou selon le préambule de la revendication 1, caractérisée en ce que l'élément optique pivotant, au nombre d'au moins un, est couplé à un levier entraîneur (82 ; 108), en ce que le levier entraîneur (82 ; 108) présente une saillie de came (87 ; 110) et en ce que la saillie (96 ; 110) agit sur une surface de came d'un disque d'entraînement (88 ; 112) motorisé.

**12.** Tête de projection selon la revendication 11, caractérisée en ce que le disque d'entraînement (88 ; 112) est pourvu d'une rainure en spirale (92 ; 114) formant la surface de came.

**13.** Tête de projection selon la revendication 11 ou 12, caractérisée en ce que le disque d'entraînement (88 ; 112) est relié à un moteur d'entraînement (83 ; 118), par une transmission à courroie.

**14.** Tête de projection selon l'une des revendications 11 à 13, caractérisée en ce que le levier entraîneur (82 ; 108) est relié rigidement à l'élément optique pivotant.

**15.** Tête de projection selon l'une des revendications 11 à 14, caractérisée en ce que le levier entraîneur (82 ; 108), monté pivotant, est précontraint au moyen d'un élément à ressort (98 ; 120), dans l'un des deux sens de pivotement.

**16.** Tête de projection selon l'une des revendications 11 à 15, caractérisée par un interrupteur de fin de course (102, 122), actionné par le levier entraîneur (82 ; 108).

Fig. 1

Fig. 2

EP 0 429 461 B1

13